Europäisches Patentamt

(19) European Patent Office

Office européen des brevets

(11) Numéro de publication : **0 006 372**
**B1**

(12) **FASCICULE DE BREVET EUROPÉEN**

(45) Date de publication du fascicule du brevet : 14.09.83

(21) Numéro de dépôt : 79400346.7

(22) Date de dépôt : 31.05.79

(51) Int. Cl.³ : **H 01 S 3/06**

(54) **Laser à réflecteur distribué.**

(30) Priorité : 09.06.78 FR 7817281

(43) Date de publication de la demande :
09.01.80 Bulletin 80/01

(45) Mention de la délivrance du brevet :
14.09.83 Bulletin 83/37

(84) Etats contractants désignés :
DE FR GB NL SE

(56) Documents cités :
FR A 2 257 918
US A 4 054 363

OPTICS COMMUNICATIONS, vol. 17, n° 3, juin 1976, Amsterdam, Pays-Bas H.W. YEN et al. : « GaAs distributed Bragg reflector lasers », pages 213-8

ELECTRONICS LETTERS, vol. 13, n° 25, décembre 1977, Grande-Bretagne Y. VEMATSU et al. : « Grating-coupled GaAs-GaAlAs lasers with distributed Bragg reflectors », pages 759-760

(73) Titulaire : THOMSON-CSF
173, Boulevard Haussmann
F-75379 Paris Cedex 08 (FR)

(72) Inventeur : Puech, Claude
"THOMSON-CSF" - SCPI 173, bld Haussmann
F-75360 Paris Cedex 08 (FR)
Inventeur : Leclerc, Pierre
"THOMSON-CSF" - SCPI 173, bld Haussmann
F-75360 Paris Cedex 08 (FR)
Inventeur : de Cremoux, Baudouin
"THOMSON-CSF" - SCPI 173, bld Haussmann
F-75360 Paris Cedex 08 (FR)
Inventeur : Hirtz, Pierre
"THOMSON-CSF" - SCPI 173, bld Haussmann
F-75360 Paris Cedex 08 (FR)
Inventeur : Diforte, Marie-Antoinette
"THOMSON-CSF" - SCPI 173, bld Haussmann
F-75360 Paris Cedex 08 (FR)

(74) Mandataire : Desperrier, Jean-Louis et al
THOMSON-CSF SCPI 173, Bld Haussmann
F-75379 Paris Cedex 08 (FR)

## Laser à réflecteur distribué

L'invention a pour objet un laser à semiconducteur à réflecteur distribué.

On connaît en effet deux sortes de lasers à semiconducteur. Les lasers à faces clivées qui comprennent une diode formée d'un monocristal clivé sur deux faces, et dans ce cristal une zone dite « active » dans laquelle, quand la diode est polarisée en direct, se recombinent les électrons et les trous. La couche active, s'étendant parallèlement aux jonctions et limitée par les deux faces clivées, forme une cavité de Pérot Fabry, ce qui permet d'amplifier la lumière qui est émise à l'extérieur par les deux faces clivées. Ces lasers sont peu directifs, et la zone active ayant une épaisseur de l'ordre de 0,1 à 1 μm ne peut pas être facilement couplée à une fibre optique, avec un rendement convenable.

En second lieu, les lasers à résonateur distribué, ou à réflecteurs distribués, qui comprennent au lieu de deux miroirs localisés, une ou deux structures spatiales périodiques de l'un des paramètres dont dépend la propagation de la lumière, une structure périodique étant répartie le long de la zone active pour les lasers à résonateur, ou étant située de part et d'autre de la zone active pour les lasers à réflecteurs distribués. De tels lasers sont décrits dans le document Electronics Letters, vol. 13, n° 25, décembre 1977, Grande-Bretagne par Y. YEMATSU et al. « Grating-coupled GaAs-GaAlAs lasers with distributed Bragg reflectors » pages 759-760. Le document FR-A-22 57918 suggère une structure à guide d'onde munie de cannelures qui par pompage optique peut émettre transversalement un rayonnement. La publication Optics communications, vol. 17, n° 3, juin 1976, Amsterdam, Pays-Bas, pp. 213-218 fournit des indications similaires dans un article de H. W. YEN et al. intitulé « GaAs distributed Bragg reflector lasers ».

Ces lasers présentent des particularités intéressantes, car la lumière émise par effet de diffraction se propage perpendiculairement aux jonctions, lorsque le deuxième ordre de contre-réaction est utilisé, ce qui permet de les coupler facilement à une fibre optique.

Ils présentent néanmoins l'inconvénient d'être difficiles à fabriquer du fait que les structures périodiques sont formées sur le semiconducteur et qu'une couche épitaxiée doit ensuite être formée sur la surface photogravée. De plus, la lumière émise est une source de chaleur. Il en résulte la nécessité de placer un système de refroidissement du côté des couches épitaxiées. La lumière émise orthogonalement à la structure périodique doit alors traverser le substrat, ce qui diminue fortement le rendement de telles diodes.

La présente invention a pour objet un laser à semiconducteur qui tout en ayant les avantages de ces deux types de lasers, n'en a néanmoins pas les inconvénients.

Le laser à réflecteur distribué comporte une couche active siège de l'émission stimulée continue dans une cavité optique dont l'un des miroirs est constitué par une face latérale plane clivée du corps semiconducteur, l'autre miroir de ladite cavité étant formé par une structure spatiale périodique de pas P égal à un multiple entier de la demi-longueur d'onde apparente de l'émission et constituant un réseau de diffraction permettant de diffracter une fraction du rayonnement incident perpendiculairement au réseau et de réinjecter la fraction restante dans ladite cavité optique, caractérisé en ce que ladite structure spatiale périodique est formée sur une face d'un guide d'onde rapporté périodique est formée sur une face d'un guide d'onde rapporté constitué d'un milieu diélectrique transparent disposé par l'intermédiaire d'un milieu de couplage optique contre la face latérale plane de la couche active opposée à ladite face clivée de telle sorte que ladite cavité optique résulte de l'association hybride dudit guide d'onde et de ladite couche active.

L'invention sera mieux comprise au moyen de la description ci-après en se référant aux dessins ci-après parmi lesquels :

la figure 1 représente en coupe, un exemple de réalisation de l'invention ;

la figure 2 représente en coupe, un détail de la figure 1 ;

la figure 3 représente en coupe un deuxième exemple de réalisation de l'invention ;

la figure 4 représente vu du dessus l'exemple de la figure 3 ;

la figure 5 est une courbe explicative ;

la figure 6 représente en perspective un guide d'onde avec résonateur distribué fait d'un matériau électro-optique ;

la figure 7 représente un laser multiple à réflecteurs distribués ;

la figure 8 est une courbe explicatrice.

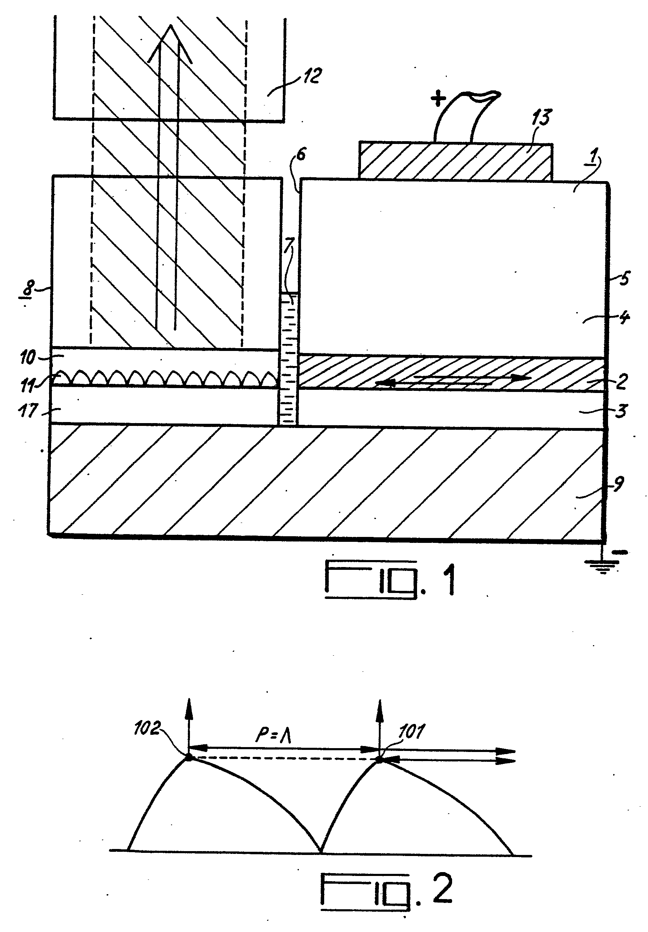

Sur la figure 1 est représenté un corps semiconducteur 1 composé d'un substrat d'arséniure de gallium 4 et de couches épitaxiées 2 et 3 en GaAlAs, les proportions d'Al et d'As (Aluminium et Arsenic) n'étant pas les mêmes dans les couches 2 et 3 de façon à former des hétérojonctions. La couche 2 dite zone active dopée n est limitée latéralement sur la partie droite par une face clivée 5 du bloc. La couche inférieure 3 du bloc a une conductivité de type n et le substrat 4 a une conductivité de type p. Ces couches ont des largeurs de bande interdite telles que si l'ensemble est polarisé en direct, les électrons et les trous se recombinent dans la couche active 2 pour former un rayonnement lumineux.

Conformément à l'invention, l'autre face 6 est couplée par l'intermédiaire d'un liquide d'adaptation d'indice 7 à un bloc de verre 8. La jonction 1 est soudée côté couches épitaxiées sur un socle fait de métal (cuivre) 9, assurant un contact électrique sur la jonction et permettant le refroidissement de l'ensemble. Le bloc de verre 8 repose par l'intermédiaire d'une cale 7 sur le socle 9. Dans le bloc de verre, a été réalisé suivant les méthodes connues, un guide d'onde optique 10, par exemple par variation d'indice de réfraction. Ce guide d'onde est couplé par l'intermédiaire du liquide 7 à la zone active 2. Sur une des parois de ce guide d'onde a été gravée, par des procédés connus de photolithographie holographique et d'usinage ionique, une structure périodique 11 de pas P.

L'indice de la couche active 2 étant $n_1$, celui du verre $n_2$, l'indice $n_3$ du liquide sera choisi de façon à ce que $n_3 \simeq \sqrt{n_1 n_2}$. Un contact 13 est pris sur la face supérieure de la diode 1. Le bloc de verre 8 est couplé à une fibre optique 12.

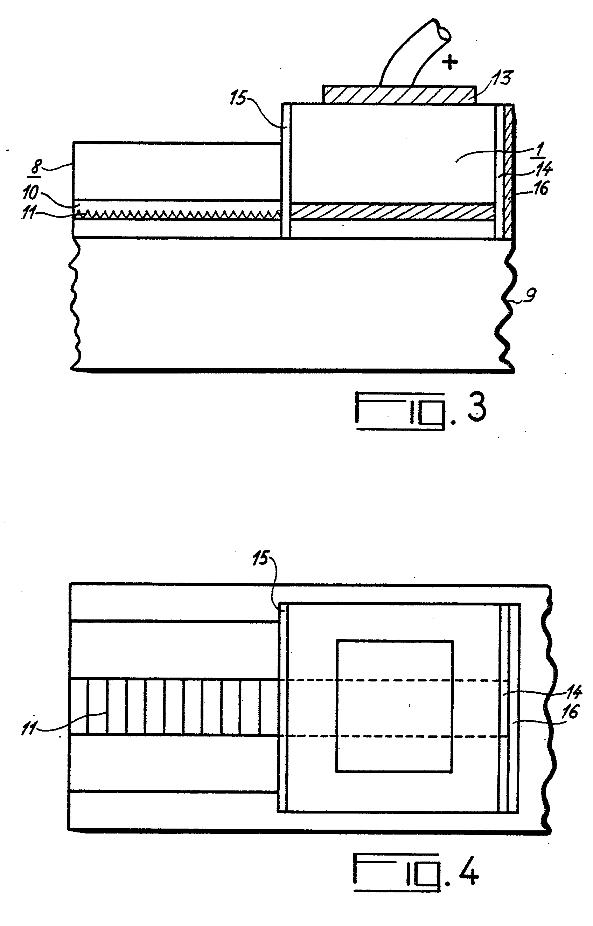

Le fonctionnement de l'ensemble est le suivant : la jonction étant polarisée en direct, si le pas du réseau P est choisi égal à k fois (k entier) la demi-longueur d'onde apparente $\lambda/2n_2$ dans le verre, k étant d'ordre de contre-réaction et correspondant à une fréquence comprise dans la bande passante déterminée par la bande interdite de la couche 2, l'ensemble zone active-guide d'onde forme un laser, comportant une cavité de type « Pérot-Fabry » dont un des miroirs est la face clivée du cristal situé à droite de la figure et l'autre, le réflecteur distribué formé dans le guide d'onde 10. Cependant si comme on peut le voir sur la figure 2, le pas P est égal à $\Lambda = \lambda/n_2$ ce qui correspond à $k = 2$, les rayons émergent des aspérités en concordance de phase. Dans le guide, sont en phase, le rayon réfléchi provenant de l'aspérité 101 et le rayon réfléchi par l'aspérité suivante 102. En effet, le trajet aller retour entre deux aspérités successives a pour longueur $2\Lambda$. Ainsi, le réflecteur distribué fonctionne suivant le deuxième ordre de contre-réaction, et toutes les aspérités étant excitées en phase, une onde est rayonnée suivant l'ordre « 0 » de diffraction dans le sens de la flèche, perpendiculairement au réseau. Cette onde est transmise par le bloc de verre et couplée à la fibre optique 12. On a ainsi obtenu un triple avantage.

a) l'indice de réfraction dans le verre est plus petit que dans l'Arséniure de Gallium. $n_1 = 3,6$, $n_2 = 1,5$. Le pas du réseau pourra être 2,4 fois plus grand que dans un laser en GaAs à résonateur distribué ou à réflecteurs distribués dans lesquels les structures périodiques sont réalisées directement dans l'arséniure de gallium, pour un fonctionnement suivant le même ordre de contre-réaction.

b) la non-transparence du substrat GaAs au rayonnement ne pose aucun problème, puisque le rayonnement vers l'extérieur se fait par l'intermédiaire du verre.

c) enfin, le pas du réseau permet de sélectionner avec une grande précision, la raie d'émission dans les bandes passantes du « laser ».

D'autres dispositifs sont réalisables sans sortir du cadre de l'invention.

La figure 3 représente en coupe, et la figure 4 vu du dessus, un second mode de réalisation. Le corps semiconducteur 1 est recouvert sur sa face clivée et sur la face opposée respectivement de deux couches 15 et 14 diélectriques transparentes et d'épaisseur correspondant à un quart de longueur d'onde compte tenu de l'indice de réfraction dans ces couches. De telles couches évitent d'une part que la réflexion sur la face extérieure des couches 14 et 15 participent à la contre-réaction. En effet, les ondes réfléchies sont en opposition de phase avec les ondes provenant de la contre-réaction par le réflecteur distribué. Ceci permet pour éviter les rayonnements parasites de recouvrir d'une couche 16 d'or la couche 14 et enfin de supprimer le liquide d'adaptation d'indice. Le dispositif est alors simplifié, son rendement est amélioré, tout rayonnement vers la droite étant éliminé, ainsi que les pertes dans le liquide d'adaptation qui n'est plus nécessaire.

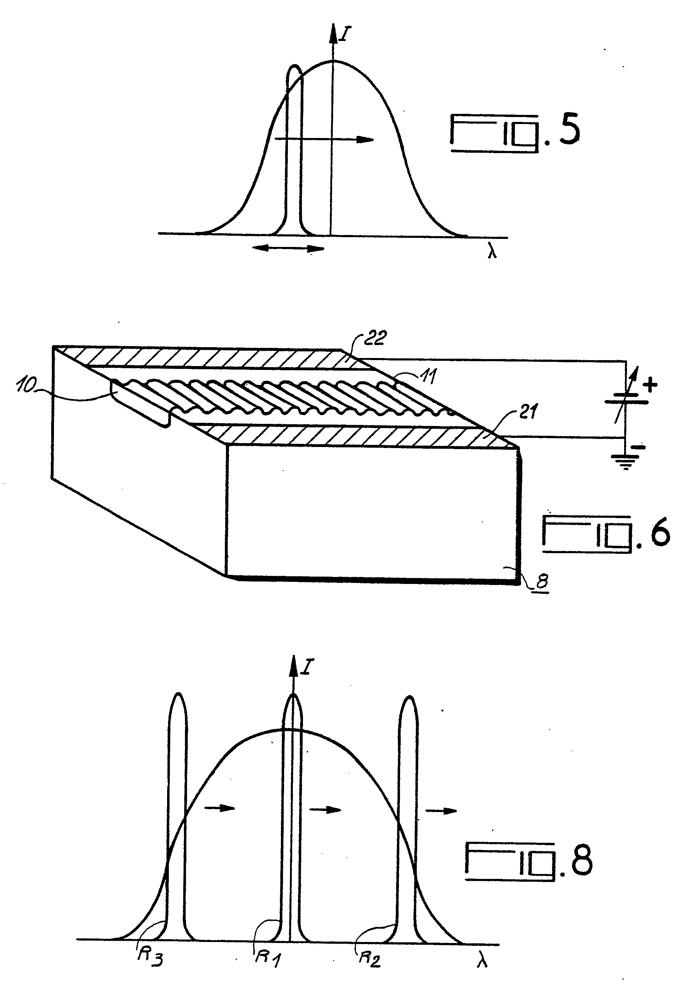

Une autre possibilité est offerte par l'invention. Le guide d'onde, et le réflecteur distribué associé, peuvent être réalisés dans un matériau électro-optique par exemple le Niobate de Lithium (LiNb $O_3$). On sait en effet réaliser des guides d'ondes par diffusion dans un tel matériau d'ions métalliques, par exemple de Titane (Ti). Un tel guide d'onde et le substrat associé sont représentés figure 6, le guide d'onde 10 obtenu par diffusion métallique dans le substrat 8, a pour la commodité de la compréhension été représenté retourné par rapport aux figures précédentes. En plaçant deux électrodes d'or 21 et 22 de part et d'autre du guide d'onde, et en appliquant entre ces deux électrodes un potentiel variable on peut faire varier l'indice de réfraction n dans le matériau et par conséquent la longueur d'onde émise $\lambda$. Ceci permet un ajustement fin de la longueur d'onde émise.

La figure 5, montre la courbe d'énergie lumineuse en fonction de la longueur d'onde $\lambda$. Le réflecteur distribué permet de sélectionner une raie étroite dans cette bande. De plus, par réglage de la tension appliquée entre les deux électrodes, par exemple en faisant varier graduellement la tension de 0 à 10 ou 20 V, on peut sélectionner des « raies » d'émission avec un réseau de pas P défini. Si le guide d'onde formé dans le niobate de lithium a un indice $n = 2,3$ la variation d'indice induite pour une variation de tension de 1 V est $\Delta n = 10^{-3}$. La longueur d'onde émise $\lambda = 2nP/k$ a une variation relative $\Delta\lambda/\lambda = \Delta n/n$, soit pour $\lambda = 8\,600$ Å, $\Delta\lambda = 3,7$ Å.

On peut donc ainsi dans la bande du « laser » régler avec une précision très grande la fréquence d'émission, c'est-à-dire par application d'une tension donnée choisir avec une très grande précision la raie d'émission dans la bande d'émission du laser.

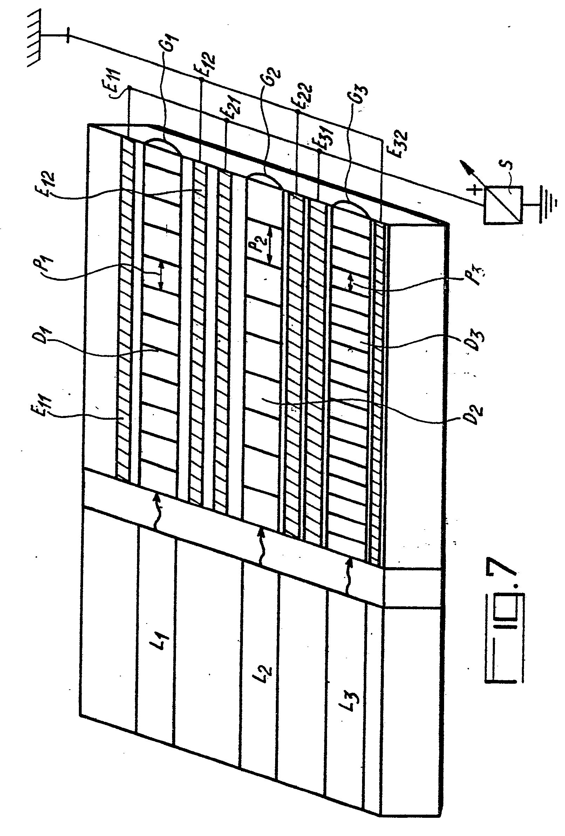

La figure 7 représente très schématiquement un laser multiple permettant en utilisant des réseaux de pas P différents, d'obtenir des longueurs d'ondes émises différentes. L'ensemble représente en perspective trois lasers $L_1$, $L_2$ et $L_3$ formés sur le même substrat et représentés vus du côté des couches épitaxiales, les lasers $L_1$, $L_2$ et $L_3$ sont disposés parallèlement et formés dans la même couche active. On sait en effet par des techniques connues confiner l'émission stimulée dans des portions définies de la zone active d'une diode électroluminescente.

Les lasers $L_1$, $L_2$ et $L_3$ sont couplés à trois guides d'onde $G_1$, $G_2$, $G_3$ formés comme dans la figure 6 dans un matériau électro-optique. Sur ces guides sont formés des réflecteurs distribués $D_1$, $D_2$, $D_3$ de pas différents $P_1$, $P_2$, $P_3$. Ils sont commandés respectivement par des électrodes $E_{12}$, $E_{22}$, $E_{32}$ à la masse, $E_{11}$, $E_{21}$, $E_{31}$ reliés à une même borne + d'une source de tension variable S.

A chaque pas correspond une raie $R_1$, $R_2$ ou $R_3$ (figure 8) et une variation de tension permet le déplacement des raies.

## Revendications

1. Laser à réflecteur distribué comportant une couche active (2) siège de l'émission stimulée contenue dans une cavité optique dont l'un des miroirs est constitué par une face latérale plane clivée (5) du corps semiconducteur (1), l'autre miroir de ladite cavité étant formé par une structure spatiale périodique (11) de pas P égal à un multiple entier de la demi-longueur d'onde apparente de l'émission et constituant un réseau de diffraction permettant de diffracter une fraction du rayonnement incident perpendiculairement au réseau et de réinjecter la fraction restante dans ladite cavité optique, caractérisé en ce que ladite structure spatiale périodique (11) est formée sur une face d'un guide d'onde rapporté (10) constitué d'un milieu diélectrique transparent disposé par l'intermédiaire d'un milieu de couplage optique (7 ; 15) contre la face latérale plane (6) de la couche active (2) opposée à ladite face clivée (5) de telle sorte que ladite cavité optique résulte de l'association hybride dudit guide d'onde et de ladite couche active.

2. Laser suivant la revendication 1, caractérisé en ce que ladite structure spatiale périodique (11) est un réseau diffracteur fonctionnant dans le second ordre de contre-réaction destiné à émettre une onde diffractée d'ordre 0 dans la direction perpendiculaire au réseau, l'onde diffractée étant couplée à l'entrée d'une fibre optique (12) ayant un axe parallèle à ladite direction.

3. Laser suivant la revendication 2, caractérisé en ce qu'un milieu (7) d'adaptation d'indice de réfraction approprié est interposé entre la couche active (2) et le guide d'onde rapporté (10).

4. Laser suivant la revendication 2, caractérisé en ce que ladite face clivée (5) est recouverte d'une lame quart d'onde (14), une autre lame quart d'onde (15) étant interposée entre le guide d'onde rapporté (10) et la couche active (2).

5. Laser suivant la revendication 2, caractérisé en ce que le guide d'onde rapporté (10) est fait de silice.

6. Laser suivant la revendication 2, caractérisé en ce que le guide d'onde rapporté (10) est fait d'un matériau électro-optique.

7. Laser suivant la revendication 6, caractérisé en ce que des électrodes (21, 22) sont prévues de part et d'autre du guide d'onde rapporté (10), pour faire varier l'indice de réfraction du milieu électro-optique et par conséquent le pas apparent de la structure réfléchissante en réseau, ceci ayant pour conséquence de faire varier la fréquence émise dans la bande passante du « laser ».

8. Laser à réflecteur distribué du type comportant une couche active (2) siège de l'émission stimulée contenue dans une cavité optique dont l'un des miroirs est constitué par une face latérale plane clivée (5) du corps semiconducteur (1), l'autre miroir de ladite cavité étant formé par une structure spatiale périodique de pas P égale à un multiple entier de la demi-longueur d'onde apparente de l'émission et constituant un réseau de diffraction permettant de diffracter une fraction du rayonnement incident perpendiculairement au réseau et de réinjecter la fraction restante dans ladite cavité optique, caractérisé en ce qu'il comporte un agencement de plusieurs structures périodiques collatérales ($D_1$, $D_2$, $D_3$) ayant des pas différents ; lesdites structures spatiales périodiques étant formées sur une face commune à plusieurs guides d'ondes rapportés ($G_1$, $G_2$, $G_3$) formés dans un milieu diélectrique transparent disposé par l'intermédiaire d'un milieu de couplage optique (7, 15) contre la face latérale plane (6) de la couche active (2) opposée à ladite face clivée (5) de telle sorte que plusieurs cavités optiques collatérales résultent de l'association hybride de chacun desdits guides d'onde et de zones actives ($L_1$, $L_2$, $L_3$) formées dans ladite couche active (2).

## Claims

1. Distributed reflector laser comprising an active layer (2) where the stimulated emission occurs and which is contained within an optical cavity having one of its mirrors formed by a plane lateral cleaved face (5) of the semiconductor body (1), the other mirror of said cavity being formed by a periodic spatial structure (11) having a pitch P equal to an integer multiple of the apparent half-wavelength of the emission and forming a diffraction grid allowing the diffraction of a fraction of the incident radiation perpendicularly to the grid and the reinjection of the remaining fraction into said optical cavity, characterized in that said spatial periodic structure (11) is formed on one face of a seated waveguide (10) formed of a dielectric transparent medium applied against the lateral plane face (6) of the active layer (2) opposite to said cleaved face (5) with the interposition of an optical coupling medium (7, 15), the optical cavity thus resulting from the hybrid association of said waveguide and said active layer.

2. Laser in accordance with claim 1, characterized in that said spatial periodic structure (11) is a diffraction grid operating on the second feedback order for the emission of a diffracted wave of the order 0 in a direction perpendicular to

the grid, the diffracted wave being coupled to the input of an optical fibre (12) having its axis parallel to said direction.

3. Laser in accordance with claim 2, characterized in that an appropriate refraction index adapting medium (7) is interposed between the active layer (2) and the seated waveguide (10).

4. Laser in accordance with claim 2, characterized in that said cleaved face (5) is covered by a quarter-wavelength plate (14), a further quarter-wavelength plate (15) being interposed between the seated waveguide (10) and the active layer (2).

5. Laser in accordance with claim 2, characterized in that the seated waveguide (10) is made of silica.

6. Laser in accordance with claim 2, characterized in that the seated waveguide (10) is made of an electrooptical material.

7. Laser in accordance with claim 6, characterized in that electrodes (21, 22) are provided on both sides of the seated waveguide (10) to make the refraction index of the electro-optical medium, and thus the apparent pitch of the reflecting grid structure, vary and thus vary the emitted frequency within the pass band of the « laser ».

8. Distributed reflector laser of the type comprising and active layer (2) where the stimulated emission occurs and which is contained within an optical cavity having one of its mirrors formed by a lateral plane cleaved face (5) of the semiconductor body (1), the other mirror of said cavity being formed by a periodic spatial structure having a pitch P equal to an integer multiple of the apparent half-wavelength of the emission and which forms a diffraction grid allowing to diffract a fraction of the incident radiation perpendicularly to the grid and to reinject the remaining fraction into the optical cavity, characterized in that it comprises an arrangement of a plurality of periodic collateral structures $(D_1, D_2, D_3)$ having different pitches ; said periodic spatial structures being formed on a common face of a plurality of seated waveguides $(G_1, G_2, G_3)$ formed within a transparent dielectric medium applied against the plane lateral face (6) of the active layer (2) opposite said cleaved face (5) with the interposition of an optical coupling medium (7, 15), a plurality of collateral optical cavities thus resulting from the hybrid association of each of said waveguides with active zones $(L_1, L_2, L_3)$ formed within said active layer (2).

**Ansprüche**

1. Laser mit verteiltem Reflektor und einer aktiven Schicht (2), in der die stimulierte Emission stattfindet und die in einem optischen Resonator enthalten ist, dessen einer Spiegel durch eine ebene, abgespaltene Seitenfläche (5) des Halbleiterkörpers (1) gebildet ist, während der andere Spiegel des Resonators durch eine räumliche periodische Struktur (11) gebildet ist, deren Teilung (P) gleich einem ganzzahligen Vielfachen der in Erscheinung tretenden Wellenlänge der Emission ist und die ein Beugungsgitter bildet, welches es ermöglicht, einen Bruchteil der einfallenden Strahlung senkrecht zu dem Gitter zu beugen und den verbleibenden Bruchteil in den optischen Resonator zurück einzuspeisen, dadurch gekennzeichnet, daß die räumliche periodische Struktur (11) auf einer Fläche eines aufgesetzten Wellenleiters (10) gebildet ist, der aus einem lichdurchlässigen dielektrischen Milieu gebildet ist, welches über Zwischenfügung eines optischen Kopplungsmilieus (7, 15) gegen die ebene Seitenfläche (6) der aktiven Schicht (2) angelegt ist, die der genannten abgespaltenen Fläche (5) gegenüberliegt, so daß der optische Resonator aus der hybriden Vereinigung des genannten Wellenleiters und der genannten aktiven Schicht resultiert.

2. Laser nach Anspruch 1, dadurch gekennzeichnet, daß die genannte räumliche periodische Struktur (11) ein Beugungsgitter ist, das mit der zweiten Gegenkopplungsordnung arbeitet, um eine gebeugte Welle der Ordnung 0 senkrecht zu dem Gitter auszusenden, wobei die gebeugte Welle in den Eingang einer optischen Faser (12) eingekoppelt ist, deren Achse parallel zu der genannten Richtung ist.

3. Laser nach Anspruch 2, dadurch gekennzeichnet, daß ein geeignetes Brechungsindex-Anspassungsmilieu (7) zwischen der aktiven Schicht (2) und dem aufgesetzten Wellenleiter (10) eingefügt ist.

4. Laser nach Anspruch 2, dadurch gekennzeichnet, daß die genannte abgespaltene Fläche (5) mit einem Viertelwellenlängenplättchen (14) belegt ist und ein weiteres Viertelwellenlängenplättchen (15) zwischen dem aufgesetzten Wellenleiter (10) und der aktiven Schicht (2) eingefügt ist.

5. Laser nach Anspruch 2, dadurch gekennzeichnet, daß der aufgesetzte Wellenleiter (10) aus Siliciumdioxid gebildet ist.

6. Laser nach Anspruch 2, dadurch gekennzeichnet, daß der aufgesetzte Wellenleiter (10) aus einem elektrooptischen Material gebildet ist.

7. Laser nach Anspruch 6, dadurch gekennzeichnet, daß Elektroden (21, 22) auf beiden Seiten des aufgesetzten Wellenleiters (10) vorgesehen sind, um den Brechungsindex des elektrooptischen Milieus und folglich die scheinbare Teilung der reflektierenden Gitterstruktur zu variieren, wodurch die ausgesandte Frequenz in dem Durchlaßband des « Lasers » veränders wird.

8. Laser mit verteiltem Reflektor von der Art mit einer aktiven Schicht (2), in der die stimulierte Emission stattfindet und die in einem optischen Resonator enthalten ist, dessen einer Spiegel durch eine seitliche ebene abgespaltene Fläche (5) des Halbeiterkörpers (1) gebildet ist, während der andere Spiegel des Resonators durch eine räumliche periodische Struktur gebildet ist, deren Teilung P gleich einem ganzzahligen Vielfachen der scheinbaren halben Wellenlänge der Emission ist und die ein Beugungsgitter bildet, welches es ermöglicht, einen Bruchteil der einfallenden Strahlung senkrecht zu dem Gitter zu beugen und den verbleibenden Bruchteil wieder in den optischen Resonator einzuspeisen, dadurch gekennzeichnet, daß er eine Anordnung aus mehreren nebeneinanderliegenden periodischen Strukturen ($D_1$, $D_2$, $D_3$) mit verschiedenen Teilungen umfaßt ; wobei die periodischen räumlichen Strukturen auf einer Fläche gebildet sind, die mehreren aufgesetzten Wellenleitern ($G_1$, $G_2$, $G_3$) gemeinsam ist, welche in einem lichtdurchlässigen dielektrischen Milieu gebildet sind, das über ein optisches Kopplungsmilieu (7, 15) gegen die ebene Seitenfläche (6) der aktiven Schicht (2) angelegt ist, die der genannten abgespaltenen Fläche (5) gegenüberliegt, so daß mehrere nebeneinanderliegende optische Resonatoren aus der hybriden Vereinigung jedes dieser Wellenleiter mit aktiven Zonen ($L_1$, $L_2$, $L_3$), die in der genannten aktiven Schicht (2) gebildet sind, resultieren.

Fig. 1

Fig. 2

Fig. 3

Fig. 4

FIG.5

FIG.6

FIG.8

Fig. 7